# DEMANDE DE BREVET EUROPEEN

(11) **EP 1 376 843 A2**
(43) Date de publication de la demande: **02.01.2004**
(21) Numéro de dépôt: 03354063.4
(22) Date de dépôt: 27.06.2003
(51) Int. Cl.: H02M 7/162, H02M 1/08

(54) **Commande d'un thyristor d'un pont redresseur**

(30) Priorité: 28.06.2002 FR 0208116
(71) Demandeur: STMicroelectronics S.A., 92120 Montrouge (FR)
(72) Inventeur: Peron, Benoît, 37000 Tours (FR)
(74) Mandataire: de Beaumont, Michel

(57) **Abrégé**

L'invention concerne un procédé et un circuit de commande d'au moins un thyristor (TH) constitutif d'un pont redresseur à sortie filtrée, consistant à provoquer la fermeture du thyristor (TH) quand la tension à ses bornes devient supérieure à zéro, et à provoquer la disparition du courant de gâchette du thyristor quand le courant dans celui-ci dépasse son courant d'accrochage.

## Description

La présente invention concerne la commande d'un thyristor utilisé dans un pont redresseur. L'invention concerne, plus particulièrement, les thyristors utilisés dans des ponts redresseurs à sortie filtrée, c'est-à-dire dont le besoin de mise en conduction du thyristor n'est pas synchrone avec les passages par zéro de la tension d'alimentation alternative du pont.

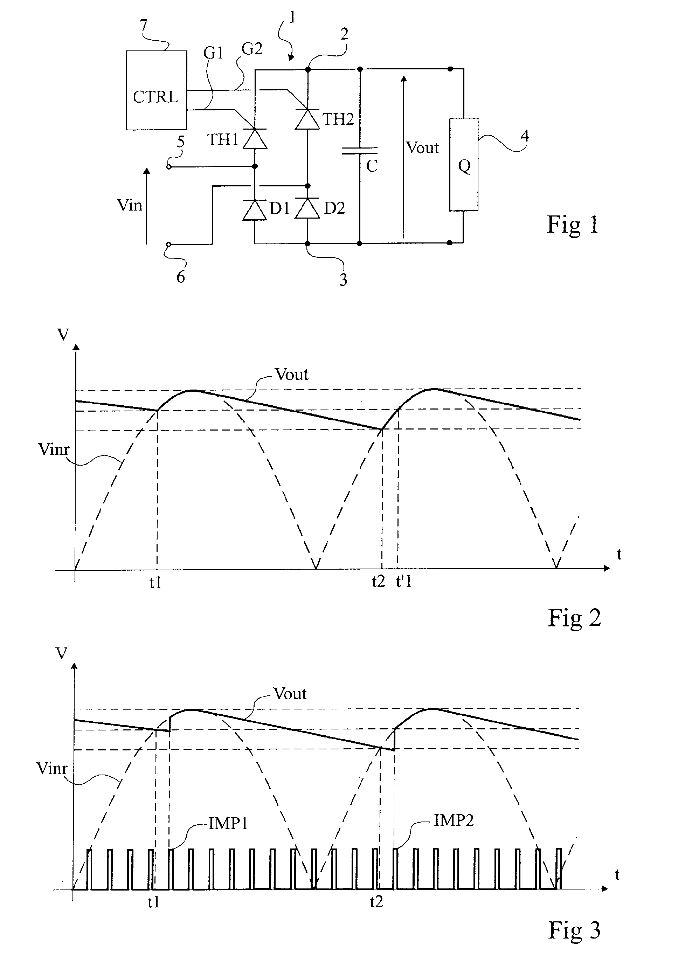

La figure 1 représente le schéma électrique d'un pont redresseur mixte double alternance du type auquel s'applique la présente invention. Plus généralement, l'invention s'applique à tout pont redresseur filtré, quel que soit le nombre de phases exploitées du signal alternatif d'entrée.

Le pont mixte 1 de la figure 1 est constitué de deux thyristors TH1 et TH2 et de deux diodes D1 et D2 connectés dans deux branches parallèles du pont entre deux bornes de sortie 2 et 3, respectivement positive et de référence. Les bornes 2 et 3 sont destinées à fournir la tension redressée qui est filtrée au moyen d'un condensateur C pour fournir une tension Vout d'alimentation continue et filtrée à une charge 4 (Q). Deux bornes d'entrée 5 et 6 du pont 1 reçoivent une tension alternative Vin. Ces bornes 5 et 6 sont reliées aux points d'interconnexion respectifs des associations en série des thyristors et diodes respectivement TH1-D1 et TH2-D2.

Les thyristors TH1 et TH2 sont commandés par un circuit 7 (CTRL) fournissant les signaux adaptés à provoquer la mise en conduction des thyristors lorsque la tension d'entrée alternative Vin excède la tension de sortie Vout, pour provoquer la recharge du condensateur C.

La figure 2 illustre, par un chronogramme, le fonctionnement d'un pont mixte tel qu'illustré par la figure 1 avec une commande des thyristors TH1 et TH2 par un courant constant. En d'autres termes, dans cet exemple, le circuit de commande 7 fournit un courant constant aux gâchettes respectives G1 et G2 des thyristors TH1 et TH2.

En figure 2, la tension de sortie Vout a été représentée en trait plein tandis que la tension alternative d'entrée Vin redressée (mais non filtrée) a été représentée par un pointillé désigné Vinr. De façon parfaitement connue, la tension Vout suit l'allure de la tension Vinr uniquement pendant les périodes de conduction du pont redresseur pour recharger le condensateur C. Entre ces périodes, le condensateur C se décharge dans la charge 4, ce qui entraîne une diminution de la tension Vout.

Dans la première alternance illustrée par la figure 2, on suppose une mise en conduction des thyristors à un instant t1. Seul l'un des thyristors TH1 ou TH2 conduit et recharge le condensateur jusqu'au milieu de l'alternance. La deuxième alternance illustrée par la figure 2 suppose une variation du courant appelé par la charge. Dans cet exemple, on suppose une augmentation de la charge entraînant une décroissance de la tension Vout plus rapide qu'avant la première alternance. Dans ce cas, l'instant t2 de conduction des thyristors du pont se trouve avancé par rapport à ce qu'aurait été cet instant (t1') de conduction sans modification de la charge. Dans la deuxième alternance, le thyristor qui conduit n'est pas le même que lors de la première alternance. Toutefois, cela ne change rien aux principes de fonctionnement.

L'exemple de la figure 2 illustre une commande ne posant aucun problème de synchronisation dans la mesure où, dès que la tension aux bornes d'un des thyristors devient positive, celui-ci se ferme instantanément, sans problème de pic de courant (fort di/dt) à la fermeture.

Toutefois, selon le type de thyristor utilisé pour constituer le pont, on rencontre d'autres problèmes.

Si l'on utilise des thyristors sensibles, c'est-à-dire ne requérant qu'un faible courant de gâchette (quelques dizaines de microampères), afin de minimiser les pertes liées à la fourniture du courant de gâchette, on se trouve confronté à un problème d'amorçage parasite dans la mesure où ce type de transistor présente une faible immunité aux variations de tension à ses bornes.

Pour éviter ce déclenchement intempestif, on peut choisir des thyristors moins sensibles. Toutefois, les pertes sont alors élevées dans la mesure où le thyristor requiert un courant de gâchette de l'ordre de quelques dizaines de milliampères pour être rendu conducteur. Un tel courant de gâchette engendre un fort courant inverse et des pertes de quelques watts à comparer avec les quelques dizaines de milliwatts des thyristors faiblement sensibles.

En pratique, on est obligé d'effectuer un compromis entre le courant de gâchette nécessaire à l'amorçage des thyristors et l'immunité aux variations de tension à ses bornes.

La figure 3 illustre, par un chronogramme, un deuxième exemple classique de commande de thyristors d'un pont mixte. Dans ce cas, il s'agit d'une commande par impulsions. Le circuit de commande 9 fournit, en permanence, un train d'impulsions (illustré en figure 3) dont la largeur des impulsions est prévue pour garantir une conduction suffisante (un courant supérieur au courant d'accrochage des thyristors) avant disparition de l'impulsion. En reprenant l'exemple de la figure 2, c'est-à-dire lors d'une première alternance de la tension alternative redressée Vinr où un croisement des courbes Vout et Vinr se reproduit à un instant t1, le déclenchement (fermeture du thyristor TH1 ou TH2) n'est pas forcément instantané. Dans l'exemple représenté, l'instant t1 est postérieur à une impulsion et il faut donc attendre le début de l'impulsion de courant suivante Imp1 pour enclencher la fermeture du thyristor. Comme en figure 2, la deuxième alternance de l'allure Vinr illustre le cas d'une augmentation de charge alimentée par le pont redresseur. Là encore, l'impulsion Imp2 de déclenchement de fermeture d'un des thyristors peut être postérieure à l'instant t2. L'écart maximum entre l'instant où les courbes Vout et Vinr se croisent et la fermeture des thyristors est conditionné par la fréquence des impulsions.

Une telle commande par train d'impulsions permet d'utiliser des thyristors peu sensibles, c'est-à-dire requérant des courants de gâchette élevés tout en limitant les pertes inverses grâce à l'absence de courant constant alimentant les gâchettes.

Toutefois, un inconvénient majeur de cette solution est qu'elle engendre des perturbations harmoniques dues aux pics de courant se produisant en raison du décalage entre les instants t1 et t2 et le début des impulsions Imp1 et Imp2. Ces pics de courant engendrent des perturbations électromagnétiques incompatibles avec certaines applications. Pour réduire ces perturbations électromagnétiques, une solution consisterait à augmenter la fréquence des impulsions. Toutefois, cela augmente alors les pertes dans la mesure où l'on se rapproche de plus en plus d'un courant constant de gâchette.

La présente invention vise à commander la fermeture de thyristors d'un pont redresseur à sortie filtrée qui pallie les inconvénients des solutions connues. En particulier, l'invention vise à permettre l'utilisation de thyristors sensibles, sans que cela conduise à des pertes élevées, ni à des perturbations électromagnétiques en raison de pics de courant.

L'invention vise également à proposer un circuit de commande minimisant la consommation en courant pour la fermeture des thyristors d'un pont redresseur commandable.

L'invention vise également à proposer une solution particulièrement adaptée à la commande d'un pont redresseur mixte.

Pour atteindre ces objets et d'autres, la présente invention prévoit un procédé de commande d'au moins un thyristor constitutif d'un pont redresseur à sortie filtrée, consistant :
à provoquer la fermeture du thyristor quand la tension à ses bornes devient supérieure à zéro ; et
à provoquer la disparition du courant de gâchette du thyristor quand le courant dans celui-ci dépasse son courant d'accrochage.

Selon un mode de mise en oeuvre de la présente invention, la tension aux bornes du thyristor est mesurée par un pont diviseur résistif unidirectionnel.

Selon un mode de mise en oeuvre de la présente invention, le courant d'accrochage dans le thyristor est détecté par mesure de la tension à ses bornes.

L'invention prévoit également un circuit de commande d'au moins un thyristor constitutif d'un pont redresseur à sortie filtrée, comportant :
un premier comparateur de commande d'un circuit de fourniture d'un courant de gâchette au thyristor, ledit comparateur détectant que la tension aux bornes du thyristor devient positive ; et
un élément d'inhibition du circuit de fourniture du courant de gâchette dès que le thyristor est traversé par un courant supérieur à son courant d'accrochage.

Selon un mode de réalisation de la présente invention, ledit premier comparateur comprend une première entrée qui reçoit le point milieu d'un pont diviseur résistif dont les bornes sont reliées, par l'intermédiaire d'une diode, aux bornes du thyristor, et une deuxième entrée qui reçoit une première tension de référence.

Selon un mode de réalisation de la présente invention, ledit premier comparateur est constitué d'un premier transistor bipolaire dont la chute de tension base-émetteur conditionne ladite première tension de référence.

Selon un mode de réalisation de la présente invention, le circuit de fourniture du courant de gâchette est constitué d'une source de courant constant commandée par un interrupteur relié à la gâchette du thyristor.

Selon un mode de réalisation de la présente invention, le circuit de fourniture de courant de gâchette comporte un deuxième transistor bipolaire dont la base est reliée au collecteur du premier transistor, l'émetteur du deuxième transistor étant connecté à une borne d'application d'une tension continue d'alimentation par l'intermédiaire d'une résistance et sa base étant reliée à cette tension d'alimentation continue par deux diodes en série.

Selon un mode de réalisation de la présente invention, le circuit comporte également :
un deuxième comparateur dont une entrée reçoit une tension proportionnelle au courant dans le thyristor et dont une deuxième entrée reçoit une deuxième tension de référence ; et
une bascule dont les entrées respectives de mise à un et de remise à zéro reçoivent les sorties du premier et deuxième comparateurs, et dont la sortie est reliée à un interrupteur de fourniture d'un courant de gâchette au thyristor.

Selon un mode de réalisation de la présente invention, le circuit commande plusieurs thyristors.

L'invention prévoit également un pont redresseur commandable.

Ces objets, caractéristiques et avantages, ainsi que d'autres de la présente invention seront exposés en détail dans la description suivante de modes de mise en oeuvre et de réalisation particuliers faite à titre non-limitatif en relation avec les figures jointes parmi lesquelles :
la figure 1 qui a été décrite précédemment représente le schéma électrique d'un pont mixte à sortie filtrée auquel s'applique à titre d'exemple la présente invention;
la figure 2 décrite précédemment illustre un premier exemple classique de commande d'un pont mixte;
la figure 3 décrite précédemment illustre un deuxième exemple classique de commande d'un pont mixte;
la figure 4 représente, sous forme de blocs, un premier mode de réalisation d'un circuit de commande d'un thyristor selon la présente invention;
les figures 5A, 5B, 5C, 5D et 5E illustrent, sous forme de chronogrammes, le fonctionnement du circuit de commande de la figure 4;
la figure 6 représente, sous forme de blocs et schématiquement, un deuxième mode de réalisation d'un circuit de commande d'un thyristor selon la présente invention;
les figures 7A, 7B, 7C illustrent, sous forme de chronogrammes, le fonctionnement du circuit de la figure 6;
la figure 8 représente le schéma électrique d'un exemple de réalisation pratique du circuit de commande de la figure 6; et
la figure 9 représente un exemple d'application de l'invention à un pont redresseur mixte double alternance.

Les mêmes éléments ont été désignés par les mêmes références aux différentes figures. Pour des raisons de clarté, les chronogrammes ne sont pas à l'échelle. Par ailleurs, seuls les éléments du circuit qui sont nécessaires à la compréhension de l'invention ont été représentés aux figures et seront décrits par la suite. En particulier, la charge alimentée par un pont redresseur selon l'invention n'a pas été détaillée et ne fait pas l'objet de la présente invention. Celle-ci s'applique à tout type de charge pourvu qu'elle soit alimentée au moyen de la sortie filtrée (par exemple, par un condensateur) d'un élément de redressement comprenant un thyristor commandé selon l'invention.

Une caractéristique de la présente invention est de provoquer la fermeture du thyristor constitutif d'un pont redresseur à sortie filtrée, quand la tension aux bornes du thyristor devient positive, et à provoquer la disparition du courant de gâchette du thyristor quand le courant le traversant dépasse une valeur choisie pour être supérieure à son courant d'accrochage, c'est-à-dire supérieure à la valeur du courant à partir duquel le thyristor reste conducteur même en cas de disparition du courant de gâchette.

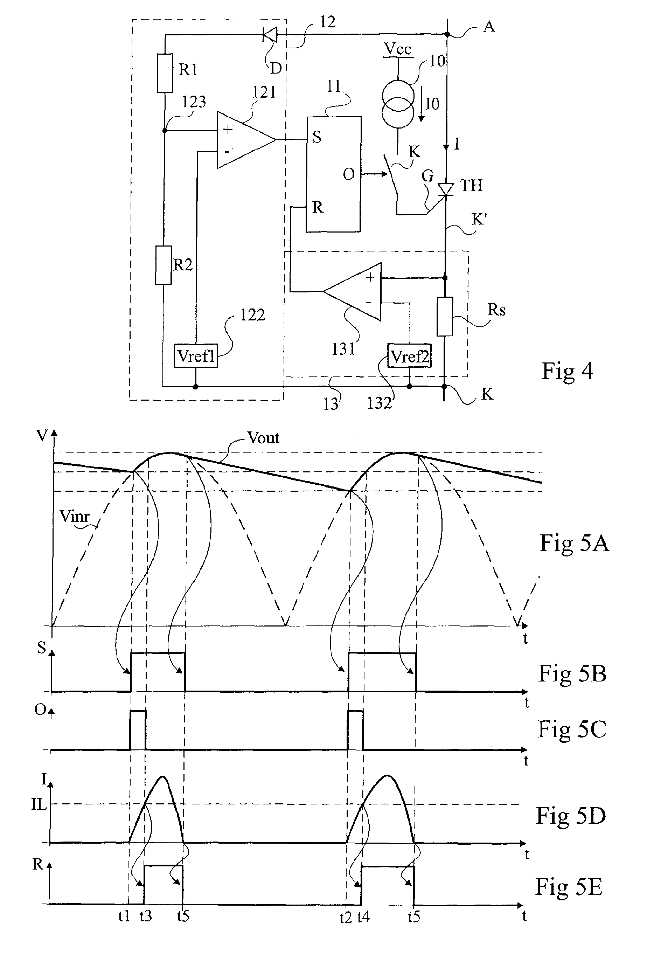

La figure 4 représente un premier mode de réalisation d'un circuit de commande selon la présente invention. En figure 4, seul un thyristor TH a été représenté entre des bornes A et K à rapprocher, dans le circuit de la figure 1, avec les bornes 5 et 2 ou avec les bornes 6 et 2. Ce thyristor est donc, par exemple, l'un quelconque des thyristors TH1 ou TH2 d'un pont redresseur mixte tel que celui de la figure 1. Plus généralement, le thyristor TH fait partie d'un pont redresseur à sortie filtrée de constitution quelconque.

Selon l'invention, la gâchette G du thyristor TH est reliée, par l'intermédiaire d'un interrupteur K, à une source de courant 10. La source 10 fournit un courant constant I0.

Selon le mode de réalisation de la figure 4, l'interrupteur K est commandé par une bascule 11 de type RS dont la sortie (O) est reliée à une borne de commande de l'interrupteur K et dont les entrées S et R sont respectivement reliées aux sorties de détecteurs de tension 12 et de courant 13. Le détecteur 12 de tension a pour rôle de mesurer la tension VAK aux bornes du thyristor TH et de détecter le passage par 0 de cette tension vers les valeurs positives. Le détecteur de courant 13 a pour objet de mesurer le courant dans le thyristor TH à l'état passant, de façon à détecter un courant supérieur au courant d'accrochage du thyristor.

Dans l'exemple de la figure 4, le détecteur 12 est constitué d'un comparateur 121 dont une entrée inverseuse reçoit une tension de référence 122 (Vref1) et dont une entrée non inverseuse est reliée au point milieu 123 d'un pont diviseur résistif formé de deux résistances R1 et R2 entre les bornes A et K du thyristor. Pour ne détecter que les passages de la tension vers les valeurs positives et rendre ainsi unidirectionnel le pont résistif, une diode D relie la borne A à une première borne de la résistance R1 dont l'autre borne est connectée au point milieu 123. La sortie du comparateur 121 est reliée à la borne de mise à un (S) de la bascule 11.

Le détecteur de courant 13 est constitué d'un comparateur 131 dont une entrée inverseuse reçoit une tension de référence 132 (Vref2) et dont une entrée non inverseuse est reliée à une première borne d'une résistance Rs de conversion courant-tension, connectée entre la cathode K' du thyristor TH et la borne K. L'entrée non inverseuse du comparateur 131 est donc reliée à l'électrode K' du thyristor TH. La sortie du comparateur 131 est reliée à la borne de réinitialisation R de la bascule 11.

Le fonctionnement du circuit de la figure 4 sera exposé par la suite en relation avec les figures 5A à 5E qui représente, sous forme de chronogrammes, des exemples d'allures caractéristiques de signaux du circuit.

La figure 5A représente un exemple d'allure de la tension Vout de sortie d'un pont redresseur filtré comprenant des thyristors commandés par le circuit de la figure 4 dans des conditions des charges similaires à celles illustrées par les figures 2 et 3 précédemment décrites. La figure 5B illustre l'allure du signal d'état de la borne de mise à un (S) de la bascule 11. La figure 5C illustre l'allure du signal O de sortie de la bascule 11, donc de commande en fermeture du commutateur K d'alimentation de la gâchette G du thyristor TH. La figure 5D illustre l'allure du courant I dans le thyristor TH. La figure 5E illustre l'allure du signal d'état de réinitialisation (R) de la bascule 11.

En figure 5A, on a illustré en pointillés l'allure d'une tension alternative redressée non filtrée Vinr comme aux figures 2 et 3. La tension Vout représentée en figure 5A correspond à la tension Vout de la figure 1 d'un pont mixte de redressement. Par conséquent, les deux alternances successives représentées en figure 5A correspondent en fait à des conductions des thyristors respectifs TH1 et TH2. Toutefois, pour simplifier, le fonctionnement sera exposé en relation avec le thyristor TH de la figure 4, étant entendu que ce fonctionnement se reproduit une alternance sur deux pour chacun des thyristors TH1 ou TH2.

Dès que la tension Vout devient inférieure à la tension Vinr, cela signifie en fait que la tension VAK aux bornes du thyristor de la branche concernée du pont devient positive. Aux figures 5A à 5E, on néglige l'éventuel seuil positif de déclenchement du circuit par rapport au zéro conditionné par la référence de tension Vref1 du comparateur 121 de la figure 4. Ainsi, dès que la tension aux bornes du thyristor devient positive (instant t1), le signal fourni par le comparateur 121 change d'état et fournit un état haut à l'entrée S de la bascule 11 (figure 5B). Comme le thyristor est, à cet instant, bloqué, aucun courant n'est détecté par le détecteur 13 (l'entrée de réinitialisation R de la bascule 11 est à un état bas). Par conséquent, la sortie O (figure 5C) de la bascule fournit un état haut conditionnant la fermeture de l'interrupteur K.

Cette fermeture de l'interrupteur K provoque l'amorçage du thyristor TH par circulation d'un courant de gâchette fourni par la source de courant 10. Dès que le courant I traversant le thyristor TH (figure 5D) devient supérieur au seuil fixé par la référence de tension Vref2, la sortie du comparateur 131 bascule et fournit un état haut en entrée de réinitialisation (figure 5E) de la bascule 11 (instant t3). Ce changement d'état provoque une remise à zéro du signal O de sortie de la bascule 11 et, par voie de conséquence, une ouverture de l'interrupteur K.

Le seuil de déclenchement du détecteur de courant est choisi en fonction du courant d'accrochage (IL) du thyristor TH, afin de garantir que sa commande soit coupée une fois que son courant a atteint le courant d'accrochage du thyristor.

Comme le thyristor est amorcé, indépendamment de sa commande de gâchette, celui-ci va rester conducteur tant qu'il est traversé par un courant direct, c'est-à-dire tant que la tension à ses bornes reste positive. Dans l'application à un pont redresseur filtré, cela signifie que le thyristor reste conducteur jusqu'à ce que la tension alternative redressée Vinr redevienne inférieure à la tension Vout stockée par le condensateur (instant t5), c'est-à-dire après le passage au sommet de l'alternance Vinr (en fait, quand le courant traversant le thyristor TH devient inférieur à son courant de maintien IH). A cet instant t5, le blocage du thyristor TH provoque le basculement vers l'état bas de la sortie du comparateur 131, dans la mesure où la tension aux bornes du thyristor n'est plus positive (en réalité, supérieure à la tension Vref2 en tenant compte du pont diviseur R1-R2).

Dans la deuxième alternance illustrée par les figures 5A à 5E, on a reproduit les mêmes exemples qu'aux figures 2 et 3 décrites précédemment, c'est-à-dire une augmentation de la charge alimentée par le pont redresseur conduisant à une diminution plus rapide de la tension Vout. Par conséquent, l'instant (t2) où la tension aux bornes du thyristor redevient nulle est avancé par rapport à l'instant t1 de l'alternance précédente. Du point de vue du circuit de commande de la figure 4, cela ne change rien, c'est-à-dire que le basculement de l'état de sortie de la bascule 11 est avancé, ce qui engendre simplement une période de conduction plus longue du thyristor TH (figure 5D). La disparition du courant dans le thyristor TH intervient, comme pour le premier cas, à partir du moment où la tension Vinr redevient inférieure à la tension Vout stockée par le condensateur (non représenté) de filtrage de la tension de sortie.

La disparition d'un état haut en entrée S (figure 5B) de la bascule 11 n'intervient qu'à un instant t5, où le thyristor TH s'ouvre par disparition du courant le traversant (en fait, courant inférieur au courant de maintien). L'instant t5 est donc indépendant des conditions de charge alimentée. Cela est toutefois sans incidence sur le courant de gâchette du thyristor dans la mesure où la disparition de l'état haut sur le signal R (figure 5E) intervient également à l'instant t5, interdisant la prise en compte de l'état sur l'entrée S.

Un avantage de la présente invention est qu'elle permet de déterminer le moment le plus opportun pour injecter un courant de commande dans la gâchette du thyristor. En effet, en mesurant la tension aux bornes mêmes de celui-ci, on évite les pics de courant à la fermeture de ce thyristor. Par conséquent, on supprime les perturbations harmoniques.

Un autre avantage de la présente invention est qu'en supprimant son courant de commande dès qu'il est fermé, on réduit les courants de fuite inverses et la consommation du circuit de commande.

Un autre avantage de l'invention est qu'elle permet de commander des thyristors de faible sensibilité avec peu de courant (fixé par la source de courant 10). En effet, comme on détecte l'amorçage du thyristor grâce au détecteur 13, on réduit au minimum le courant de commande nécessaire.

Selon une variante de réalisation non représentée, on peut utiliser le comparateur 21 (ou la bascule 11) pour appliquer une commande externe (par exemple, de mise en fonctionnement). Par exemple, l'entrée S de la bascule peut recevoir une combinaison logique (par exemple, par une porte ET) de la sortie du comparateur 121 et d'un signal logique externe de mise en marche.

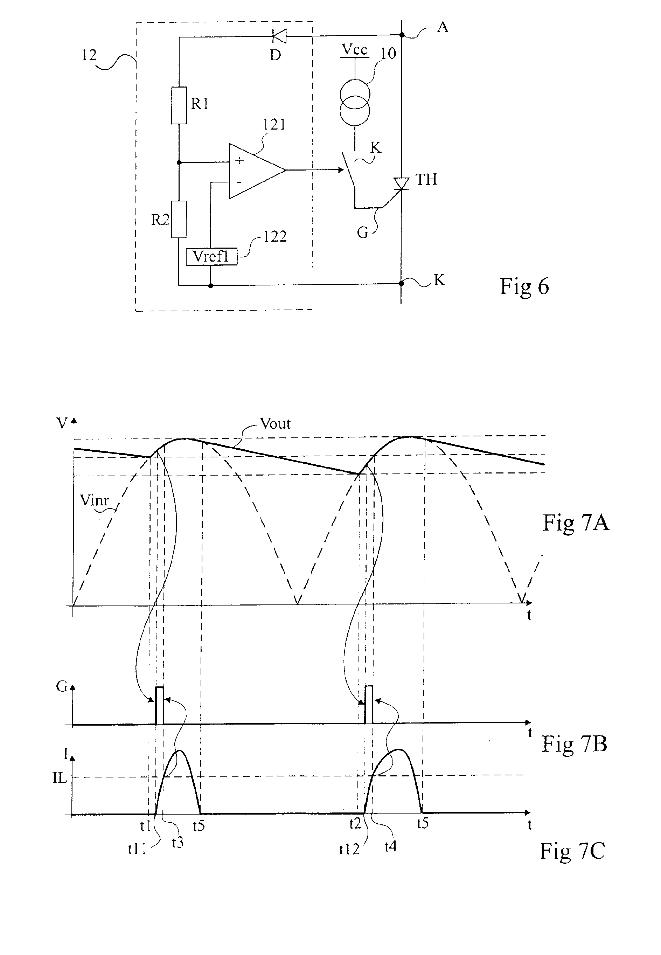

La figure 6 représente un deuxième mode de réalisation d'un circuit de commande selon la présente invention. Ce mode de réalisation tire profit des caractéristiques fonctionnelles du ou des thyristors TH commandés. On retrouve le détecteur de tension 12, l'interrupteur K et la source de courant 10 d'alimentation de la gâchette G du thyristor. La différence essentielle par rapport au schéma de la figure 4 est la suppression du détecteur de courant 13. Celui-ci est remplacé par un choix judicieux de la tension de référence Vref1 en tirant profit d'un effet de mémoire intrinsèque au thyristor TH grâce à son courant d'amorçage IL.

Selon ce mode de réalisation, la tension seuil Vref1 est choisie pour être supérieure à R2*VT/(R2+R1), où VT représente la tension seuil du thyristor TH au point de fonctionnement considéré (VT, IT), c'est-à-dire la tension VAK à partir de laquelle il peut devenir conducteur lorsque sa gâchette reçoit un courant de commande IT.

Dans une telle configuration, dès que la tension VAK aux bornes du thyristor TH dépasse la valeur (R1+R2)Vrefl/R2, le comparateur 121 ferme l'interrupteur K et le courant I0 est injecté dans la gâchette du thyristor.

Dès que le courant d'accrochage IL est atteint dans le thyristor TH, la tension VAK à ses bornes s'écroule, ce qui provoque un nouveau basculement de la sortie du comparateur 121 et l'ouverture de l'interrupteur K.

Par rapport au schéma de la figure 4, celui de la figure 6 présente l'avantage d'éviter la présence d'une résistance série Rs de conversion courant-tension pour le détecteur de courant 13 ainsi que la présence de la bascule RS 11.

Le fonctionnement du mode de réalisation de la figure 6 est illustré par les figures 7A à 7C qui représentent respectivement les allures de la tension Vout de sortie, du courant de gâchette G et du courant I dans le thyristor TH à l'état passant. Comme pour les chronogrammes précédents, l'allure de la tension redressée non filtrée Vinr a été illustrée en pointillés en figure 7A, et deux alternances successives représentant deux conditions de charge alimentées ont été représentées.

Dans la première alternance de la tension Vinr, lorsqu'à l'instant t1 la tension Vout devient inférieure à cette tension Vinr, la tension VAK aux bornes du thyristor TH devient positive. En raison du seuil Vref1 choisi, la sortie du comparateur 121 ne bascule pas immédiatement, mais avec un léger retard (instant t1). Ce basculement provoque la fermeture de l'interrupteur K et la circulation d'un courant dans la gâchette G (figure 7B). Un courant commence donc à circuler dans le thyristor TH (figure 7C). Quand ce courant I atteint le courant d'accrochage IL du thyristor, la tension VAK à ses bornes diminue, ce qui provoque le basculement inverse (instant t3) de la sortie du comparateur 121 et, par voie de conséquence, l'ouverture de l'interrupteur K et la disparition du courant de gâchette du thyristor. Ce fonctionnement est lié au choix du seuil Vref1 en fonction de la tension VT, pour que le seuil de déclenchement du comparateur 121 soit supérieur à cette tension VT. Ainsi, dès que le courant d'accrochage IL est atteint, la sortie du comparateur 121 bascule de nouveau.

Un fonctionnement similaire est reproduit dans la deuxième alternance (instants t2, t12 et t4). On voit que la durée de fermeture de l'interrupteur K est adaptée à la condition de charge, en ce sens que si la fermeture est avancée en raison d'une augmentation de la charge alimentée par le circuit, l'instant de son ouverture est également avancé. Son temps de conduction (donc la durée d'application d'un courant de gâchette) est donc réduit au strict nécessaire, en s'adaptant automatiquement à la charge alimentée.

Le retard (instant t1 à t1 et t2 à t12) à la fermeture du thyristor doit être le plus faible possible pour éviter l'apparition de pics de courant préjudiciables. Le respect de cette condition ne pose en pratique pas de problème.

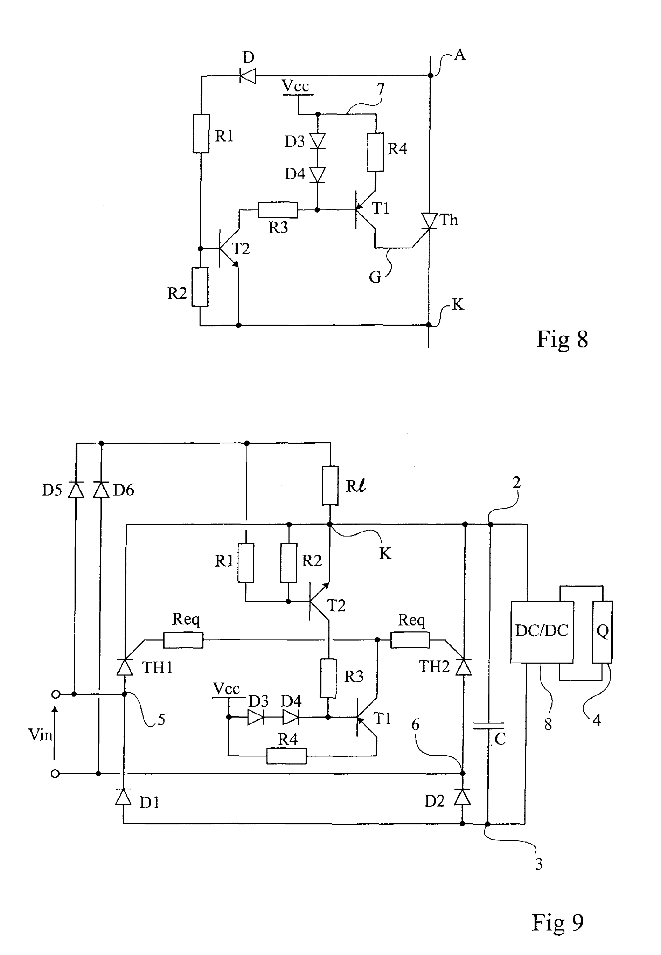

La figure 8 représente un troisième mode de réalisation d'un circuit de commande d'un thyristor TH selon l'invention. Cette figure reprend les caractéristiques de la figure 6 et détaille un exemple de réalisation pratique de son circuit. Le générateur de courant (source 10) est ici réalisé par un transistor bipolaire T1 de type PNP dont l'émetteur est relié, par une résistance R4 à une borne 7 d'application d'une tension d'alimentation continue Vcc et dont la base est reliée par deux diodes en série D3 et D4 à cette borne 7, les anodes des diodes D3 et D4 étant dirigées vers la borne 7. Le collecteur du transistor T1 est relié à la gâchette G du thyristor TH. La base du transistor T1 est reliée, par une résistance R3, au collecteur d'un deuxième transistor bipolaire T2 de type NPN remplissant la fonction du comparateur 121. La base du transistor T2 est reliée au point milieu de l'association en série des résistances R1 et R2. L'émetteur du transistor T2 est relié à la borne K (cathode du thyristor TH).

La résistance R3 a pour rôle de polariser les diodes D2 et D3 et de limiter le courant dans le transistor T2. La valeur I0 du courant fourni par la source 10 est égale à la chute de tension dans une diode polarisée en direct divisée par la résistance R4. Une des deux diodes D3 et D4 sert à compenser la tension base/émetteur du transistor T1.

La tension VAK aux bornes du thyristor TH pour laquelle un courant est injecté dans sa gâchette est donnée par la relation (R1+R2)^{*}VBE_{N}/R2+VD où VBE_{N} représente la chute de tension base-émetteur du transistor T2 (type NPN) à l'état passant.

En prenant un exemple pratique d'un thyristor dont la tension directe VT à l'état passant est au maximum d'environ 1,3 volts, et en supposant les résistances R1 et R2 égales et une chute de tension dans la diode D polarisée en direct de l'ordre de 0,7 volt, la tension base-émetteur à laquelle est soumis le transistor T2 lorsque le thyristor TH est passant est de l'ordre de 0,3 volt. Par conséquent, lorsque le thyristor conduit, le transistor T2 est bloqué (tension base-émetteur insuffisante), et aucun courant ne circule dans la gâchette du thyristor.

La figure 9 représente un exemple d'application du circuit de commande selon l'invention (dans son mode de réalisation de la figure 8) à un pont redresseur adapté à la limitation du courant d'appel à la mise sous tension du circuit.

Le pont redresseur est, comme en figure 1, constitué de deux thyristors TH1 et TH2 et de deux diodes D1 et D2. La borne 2, à laquelle sont directement reliées les cathodes des thyristors TH1 et TH2, est reliée par une première borne d'une résistance R1 de limitation du courant d'appel. La deuxième borne de la résistance R1 est reliée aux bornes 5 et 6 d'application de la tension Vin par l'intermédiaire de deux diodes de redressement D5 et D6. Les thyristors TH1 et TH2 servent à court-circuiter la résistance R1 une fois qu'une phase de démarrage du circuit est terminée. Dans cette phase de démarrage, la charge (initiale) du condensateur C s'effectue par un pont constitué des diodes D1, D2, D5 et D6. Dans l'exemple de la figure 9, le pont redresseur alimente un convertisseur continu-continu 8 (DC/DC) aux bornes de sortie duquel est connectée une charge 4 (Q).

Selon l'invention, un circuit du type de celui représenté en figure 8 sert à commander les deux thyristors TH1 et TH2. L'émetteur du transistor T2 est relié aux cathodes K des thyristors TH1 et TH2. Le pont diviseur R1-R2 est placé entre les cathodes des diodes D5 et D6 et la borne K commune des thyristors TH1 et TH2. Les diodes D5 et D6 jouent alors chacune à tour de rôle la fonction de la diode D d'entrée du pont diviseur R1, R2 selon l'alternance de la tension alternative d'entrée Vin. Des résistances d'équilibrage Req sont placées entre les gâchettes respectives des thyristors TH1 et TH2 et le collecteur du transistor T1. Le rôle de ces résistances est d'équilibrer les courants de gâchette des thyristors TH1 et TH2, en raison d'éventuelles dispersions technologiques influant sur la tension gâchette-cathode.

Le fonctionnement du circuit de limitation du courant d'appel de la figure 9 se déduit des fonctionnements exposés en relation avec les figures précédentes.

Un avantage de la présente invention est qu'elle permet d'utiliser des thyristors faiblement sensibles donc présentant une forte immunité aux variations de tension en statique, avec un courant moyen de commande très faible, sans engendrer de pertes additionnelles liées au courant de fuite inverse.

Bien entendu, la présente invention est susceptible de diverses variantes et modifications qui apparaîtront à l'homme de l'art. En particulier, les dimensionnements des seuils de tension et des résistances seront choisis en fonction des caractéristiques des thyristors utilisés. De plus, bien que l'invention ait été décrite ci-dessus en relation avec un pont mixte double alternance, celle-ci peut être mise en oeuvre dans n'importe quelle structure de redressement utilisant au moins un thyristor. En outre, l'invention peut s'appliquer à un pont mixte dans lequel les positions respectives des diodes et thyristors sont inversées par rapport aux ponts des figures 1 et 9. L'adaptation du circuit de commande est à la portée de l'homme du métier à partir des indications fonctionnelles données ci-dessus.

## Revendications

1. Procédé de commande d'au moins un thyristor (TH) constitutif d'un pont redresseur à sortie filtrée, **caractérisé en ce qu'**il consiste :
à provoquer la fermeture du thyristor (TH) quand la tension à ses bornes devient supérieure à zéro ; et
à provoquer la disparition du courant de gâchette du thyristor quand le courant dans celui-ci dépasse son courant d'accrochage.

2. Procédé selon la revendication 1, **caractérisé en ce que** la tension aux bornes du thyristor (TH) est mesurée par un pont diviseur résistif (R1-R2) unidirectionnel.

3. Procédé selon la revendication 1 ou 2, **caractérisé en ce que** le courant d'accrochage dans le thyristor (TH) est détecté par mesure de la tension à ses bornes.

4. Circuit de commande d'au moins un thyristor (TH) constitutif d'un pont redresseur à sortie filtrée, **caractérisé en ce qu'**il comporte :
un premier comparateur (121) de commande d'un circuit de fourniture d'un courant de gâchette au thyristor, ledit comparateur détectant que la tension aux bornes du thyristor devient positive ; et
un élément d'inhibition du circuit de fourniture du courant de gâchette dès que le thyristor est traversé par un courant supérieur à son courant d'accrochage.

5. Circuit selon la revendication 4, **caractérisé en ce que** ledit premier comparateur comprend une première entrée qui reçoit le point milieu d'un pont diviseur résistif (R1-R2) dont les bornes sont reliées, par l'intermédiaire d'une diode (D), aux bornes (A, K) du thyristor (TH), et une deuxième entrée qui reçoit une première tension de référence (Vref1, VBE_{N}).

6. Circuit selon la revendication 4, **caractérisé en ce que** ledit premier comparateur est constitué d'un premier transistor bipolaire (T2) dont la chute de tension base-émetteur (VBE_{N}) conditionne ladite première tension de référence.

7. Circuit selon l'une quelconque des revendications 4 à 6, **caractérisé en ce que** le circuit de fourniture du courant de gâchette est constitué d'une source de courant constant (10 ; D3, D4, T1, R4) commandée par un interrupteur (K, T1) relié à la gâchette (G) du thyristor (TH).

8. Circuit selon la revendication 7 dans son rattachement à la revendication 6, **caractérisé en ce que** le circuit de fourniture de courant de gâchette comporte un deuxième transistor bipolaire (T1) dont la base est reliée au collecteur du premier transistor (T2), l'émetteur du deuxième transistor étant connecté à une borne d'application d'une tension continue d'alimentation (Vcc) par l'intermédiaire d'une résistance (R4) et sa base étant reliée à cette tension d'alimentation continue par deux diodes (D3, D4) en série.

9. Circuit selon la revendication 5, **caractérisé en ce qu'**il comporte :
un deuxième comparateur (131) dont une entrée reçoit une tension proportionnelle au courant dans le thyristor (TH) et dont une deuxième entrée reçoit une deuxième tension de référence (Vref2) ; et
une bascule (11) dont les entrées respectives de mise à un (S) et de remise à zéro (R) reçoivent les sorties du premier et deuxième comparateurs, et dont la sortie (O) est reliée à un interrupteur (K) de fourniture d'un courant de gâchette au thyristor.

10. Circuit de commande selon l'une quelconque des revendications 5 à 9, **caractérisé en ce qu'**il commande plusieurs thyristors (TH1, TH2).

11. Pont redresseur commandable comprenant au moins un thyristor (TH1, TH2), **caractérisé en ce qu'**il comporte un circuit de commande conforme à l'une quelconque des revendications 5 à 10.
